# FASCICULE DE BREVET EUROPEEN

(11) **EP 2 496 736 B1**
(45) Date de publication et mention de la délivrance du brevet: **22.02.2017**
(21) Numéro de dépôt: 10798159.9
(22) Date de dépôt: 03.11.2010
(51) Int. Cl.: C30B 9/00, C30B 17/00, C30B 19/02, C30B 19/04, C30B 19/06, C30B 29/22, C30B 29/24, C30B 29/04

(54) **PROCEDE DE PREPARATION DE SESQUIOXYDES CUBIQUES MONOCRISTALLINS ET LEURS APPLICATIONS**
VERFAHREN ZUR HERSTELLUNG VON KUBISCHEN EINKRISTALL-SESQUIOXIDEN UND IHRE VERWENDUNG
METHOD FOR PREPARING SINGLE-CRYSTAL CUBIC SESQUIOXIDES AND USES THEREOF

(30) Priorité: 03.11.2009 FR 0957772
(43) Date de publication de la demande: 12.09.2012
(73) Titulaire: Centre National de la Recherche Scientifique, 75016 Paris (FR)
(72) Inventeur: VEBER, Philippe, F-33800 Bordeaux (FR); VELAZQUEZ, Matias, F-33400 Talence (FR); CHAMINADE, Jean-Pierre, F-33400 Talence (FR); VIRAPHONG, Oudomsack, F-33400 Talence (FR)
(74) Mandataire: Goulard, Sophie
(86) Numéro de dépôt international: PCT/FR2010/052355
(87) Numéro de publication internationale: WO 2011/055075

(56) Documents cités:
- CHEN CHANGKANG ET AL: "THE FLUX GROWTH OF SCANDIUM OXIDE CRYSTALS", JOURNAL OF CRYSTAL GROWTH, ELSEVIER, AMSTERDAM, NL LNKD- DOI:10.1016/0022-0248(90)90010-I, vol. 104, no. 3, 1 août 1990 (1990-08-01), pages 672-676, XP000161472, ISSN: 0022-0248 cité dans la demande
- WANKLYN B M ET AL: "The flux growth of large thoria and ceria crystals", JOURNAL OF CRYSTAL GROWTH, ELSEVIER, AMSTERDAM, NL LNKD- DOI:10.1016/0022-0248(84)90218-5, vol. 66, no. 2, 1 mars 1984 (1984-03-01), pages 346-350, XP024681267, ISSN: 0022-0248 [extrait le 1984-03-01]
- Y. GUYOT, R. MONGORGÉ, L.D. MERKLEM A. PINTO, B. MCINTOSH, H. VERDU: "luminescence properties of Y2O3 single crystals doped with Pr3+ or Tm3+ and codoped with Yb3+, Tb3+ or Ho3+ ions", JOURNAL OF CRYSTAL GROWTH, vol. 5, 1 janvier 1996 (1996-01-01), pages 127-136, XP002584336,
- BALDA ET AL: "First luminescence study of the new oxyborate Na3La9O3(BO3)8:Nd<3+>", OPTICAL MATERIALS, ELSEVIER SCIENCE PUBLISHERS B.V. AMSTERDAM, NL, vol. 30, no. 1, 24 juillet 2007 (2007-07-24), pages 122-125, XP022166172, ISSN: 0925-3467, DOI: DOI:10.1016/J.OPTMAT.2006.11.028

## Description

La présente invention est relative à un procédé de préparation de monocristaux massifs ou en couches minces de sesquioxydes cubiques (groupe d'espace n°206, Ia-3) de scandium, d'yttrium ou de terres rares dopés aux ions lanthanides de valence +III, par une technique de croissance en flux à haute température, et aux diverses applications des monocristaux obtenus selon ce procédé, notamment dans le domaine de l'optique.

Un laser est un appareil émettant de la lumière (rayonnement électromagnétique) amplifiée par émission stimulée. Le terme laser provient de l'acronyme anglo-américain *« light amplification by stimulated emission of radiation »* (en français : « amplification de la lumière par émission stimulée de radiation »). Le laser produit une lumière spatialement et temporellement cohérente basée sur l'effet laser. Grâce au processus d'émission stimulée, le photon émis possède le même vecteur d'onde, la même polarisation et la même phase que le photon circulant dans la cavité optique. Ceci résulte dans une source de rayonnement cohérent.

Il existe différents types de laser parmi lesquels on peut notamment citer les lasers à gaz, les lasers chimiques, les lasers à colorants organiques, les lasers à vapeurs métalliques, les lasers à solides et les lasers à semi-conducteurs.

Les lasers à solide utilisent des milieux solides, tels que des cristaux ou des verres comme milieu d'émission (spontanée et stimulée) des photons et milieu amplificateur. Le milieu amplificateur, ou encore milieu à gain, est constitué d'un matériau optiquement actif comprenant une matrice (le verre ou le cristal) rendue optiquement active par dopage par un ion qui absorbe le rayonnement d'une source de pompage optique et qui se désexcite par émission de photons. Le premier laser est un laser à rubis dont l'émission provient de l'ion Cr³⁺. D'autres ions sont très utilisés : la plupart sont des ions de terres rares : Nd³⁺, Yb³⁺, Pr³⁺, Er³⁺, Tm³⁺,... ou encore des ions de métaux de transition tels que Ti³⁺, ou Cr³⁺ entre autres. La longueur d'onde d'émission du laser dépend essentiellement de l'ion dopant pour les ions terres rares et des propriétés de la matrice dans tous les cas, l'influence de cette dernière étant beaucoup plus importante dans le cas des ions de métaux de transition. Ainsi, le verre dopé au néodyme n'émet pas à la même longueur d'onde (1053 nm) que le solide cristallin appelé « grenat » d'yttrium et d'aluminium, plus connu sous son acronyme anglais YAG signifiant «*yttrium-aluminium-garnet*»*,* et constitué d'Y₃Al₅O₁₂ dopé au néodyme (1064 nm). Les lasers à solide fonctionnent en régime continu ou en régime impulsionnel (impulsions de quelques microsecondes à quelques femtosecondes). Ils sont capables d'émettre aussi bien dans le visible, le proche et le moyen infrarouge que l'ultraviolet.

Au-delà d'une dimension de cristal de qualité optique acceptable, ces lasers permettent d'obtenir des puissances de l'ordre de la dizaine de watts en continu et des puissances plus élevées en pulsé. Ils sont utilisés pour des applications tant scientifiques qu'industrielles comme le soudage, le marquage et la découpe de matériaux.

En plus de leur utilisation dans la fabrication de lasers à forte puissance et/ou à impulsions courtes, ces matériaux solides constitués d'une matrice et d'un ion dopant peuvent également être utilisés dans la fabrication de lasers à sécurité oculaire, de lasers pour la chirurgie et /ou l'ophtalmologie (pompés diodes, impulsionnels ou continus, dans le rouge le vert et jusqu'au moyen infrarouge), de scintillateurs, de guides d'ondes, de bolomètres (détecteurs à discrimination chaleur-lumière), pour le refroidissement optique, comme matériaux luminophores ou bien encore comme matériaux pour le stockage et la manipulation de l'information quantique.

A ce jour, les solides cristallins les plus prometteurs pour l'ensemble de ces applications, et notamment pour la fabrication de lasers, sont des sesquioxydes cubiques (donc isotropes) de formule R₂O₃ dans laquelle R représente un ou plusieurs éléments choisis parmi les métaux de valence III tels que le scandium, l'yttrium et les terres rares (La, Ce, Pr, Nd, Pm, Sm, Eu, Gd, Tb, Dy, Ho, Er, Tm, Yb, Lu), dopés par des ions terre rare. Certaines d'entre eux présentent en particulier une conductivité thermique supérieure à celle du YAG dopé ion de terre rare qui est pourtant le matériau laser le plus utilisé actuellement. Ces sesquioxydes cubiques sont également intéressants dans la mesure où ils peuvent être facilement dopés par des ions terre rare et ont une forte masse volumique (de l'ordre de 4 à 9,5 g.cm⁻³ environ). De plus, les sesquioxydes d'yttrium, de scandium, de gadolinium et de lutétium présentent de basses énergies de phonons par rapport à la plupart des oxydes, en particulier du YAG.

Actuellement, ces matériaux sont principalement obtenus sous forme de céramiques transparentes préparées par frittage haute pression et haute température, de préférence sous vide. Ces céramiques présentent cependant une microstructure polycristalline avec de nombreux joints de grains diminuant les propriétés physiques à la base de leurs applications (diffusion des photons, présence d'impuretés, faible conductivité thermique, etc...).

Or, pour être utilisables de façon optimale dans ces différentes applications (laser, scintillateur, etc...), ces sesquioxydes cubiques doivent se présenter sous forme de monocristaux de taille millimétrique à centimétrique et de qualité optique suffisante.

Du fait de leur très haut point de fusion (T > 2400°C), et de leur grande réactivité chimique à l'état fondu, les conditions d'obtention de ces sesquioxydes cubiques sous forme de monocristaux et de qualité optique suffisante s'avèrent difficiles à mettre en oeuvre, coûteuses, parfois dangereuses et nécessitent la plupart du temps des traitements post-croissance de plusieurs heures à haute température (recuit).

Différentes techniques de synthèse de monocristaux de sesquioxyde de terre rare sont passées en revue par Akira Yoshikawa et Andrey Novoselov (Livre : Shaped Crystals ; Editeur : Springer Berlin Heidelberg ; Partie III, pages 187-202 ; Copyright 2007). Ces auteurs rappellent que du fait de leur très grande réactivité chimique à l'état fondu, ces matériaux doivent en principe être synthétisés selon des techniques dites « sans creuset » telles que par exemple la méthode de Veneuil (R.A. Lefever et al., Rev. Sci. Instrum., 1963, 33, 769), la technique de fusion de zone connue sous l'appellation anglaise « Laser-Heated Pedestal Growth » (LHPG) telle que décrite par D.B. Gasson et al., J. Mater. Sci., 1970, 5, 100, ou bien encore selon la technique du creuset froid ou auto-creuset connue également sous l'appellation anglaise « skull-melting » et décrite notamment par V.V. Osiko, J. Cryst. Growth, 1983, 65, 235. D'autres techniques de croissance cristalline, comme celle de J. Czochralski (Z. Phys. Chem., 1918, 92, 219) réalisent la cristallogenèse dans des creusets. Il est alors indispensable d'effectuer la croissance des cristaux dans des creusets spéciaux constitués d'un matériau dont le point de fusion est supérieur au point de fusion du matériau à faire croître, c'est-à-dire supérieur, dans le cas présent, à 2400°C, tels que des creusets en rhénium dont le point de fusion dépasse 3100°C (L. Fornasiero et al., Cryst. Res. Technol., 1999, 34, 255). Ces techniques présentent cependant l'inconvénient de conduire à des monocristaux de trop petite taille (au plus de l'ordre de quelques millimètres) et/ou présentant une qualité optique insuffisante pour les applications envisagées. Akira Yoshikawa et Andrey Novoselov proposent quant à eux l'utilisation d'une technique dite de « micro-pulling down» (µ-PD) pour effectuer la synthèse de monocristaux de sesquioxydes de terre rare, dont le principe et la mise en oeuvre permettent de réaliser des fibres monocristallines. Il s'agit d'un tirage de fibre vers le bas à partir d'une buse micrométrique placée sous un creuset dans lequel le mélange de poudre est porté à sa température de fusion. Cependant, dans le cas de la croissance de matériaux du type R₂O₃ tels que précédemment définis, cette technique nécessite cependant un appareillage spécial et coûteux (parfois non industrialisable) et ne permet d'obtenir que des cristaux en forme de fibre. Elle ne permet donc pas d'accéder à des monocristaux massifs de grandes dimensions. Par contre la technique connue sous l'acronyme HEM pour «*Heat Exchanger Method*» proposée par V. Peters et al. (J. Cryst. Growth, 2002, 237-239, 879-883) permet d'obtenir des monocristaux du type R₂O₃ de plusieurs centimètres par le refroidissement lent du fond d'un creuset en Rhénium contenant un bain fondu de R₂O₃ porté à la température de fusion (T>2400°C). Néanmoins cette technique est impossible à transposer dans l'industrie du fait de son coût très élevé (prix du rhénium par ex.), de sa dangerosité et de la forte réactivité chimique des éléments entre eux présents au sein du four. En effet, les céramiques réfractaires et le creuset en rhénium, en présence du dihydrogène H₂ (gaz de l'atmosphère de croissance explosif, par conséquent très dangereux à haute température), présentent de forts signes d'attaque chimique (noircissement des céramiques réfractaires, dissolution du creuset engendrant la contamination des cristaux) après croissance et nécessitent alors leur remplacement quasi systématique après seulement quelques croissances.

Il a également déjà été proposé, notamment dans la demande de brevet US 2009/0151621, de synthétiser des sesquioxydes de type R₂O₃, et en particulier de scandium, sous forme monocristalline par voie hydrothermale. Ce procédé consiste à dissoudre une poudre de R₂O₃ où R représente un ou plusieurs éléments choisis parmi le scandium, l'yttrium et les lanthanides, dans une solution aqueuse contenant des ions hydroxyde, puis à porter la solution résultante à une température de 450°C à 750°C sous une pression pouvant aller de 4 à 40 kpsi (soit environ de 3.10⁷ à 3.10⁹ Pa.). Ce procédé conduit à des monocristaux de R₂O₃ dont la taille peut varier de l'ordre de quelques mm au centimètre, cependant il nécessite une mise en oeuvre à très forte pression et par conséquent un appareillage adapté et nécessairement coûteux. Cette technique présente l'inconvénient d'utiliser des solutions très corrosives avec leur environnement induisant alors l'attaque chimique des creusets en argent utilisés comme contenant. Ceci provoqué alors la contamination des cristaux par les ions Ag⁺ qui s'ajoute à celle des ions OH⁻ présents initialement dans la solution. De plus la vitesse de croissance des cristaux par voie hydrothermale est très lente (généralement inférieure à 0,5 mm/jour), ce qui impose des durées de croissance extrêmement longues pour espérer atteindre une taille de cristaux de l'ordre du centimètre.

Enfin, des essais de croissance d'oxyde de scandium Sc₂O₃ à partir d'une solution à haute température à base d'oxyde de plomb PbO et/ou de fluorure de plomb PbF₂ (tous deux très toxiques) et d'oxyde de vanadium V₂O₅ ont été réalisés par Chen et al. (J. Cryst Growth, 1990, 104, 672-676). Les températures de croissance employées sont en général supérieures à 1300°C et n'ont conduit qu'à des cristaux de taille millimétrique et de qualité optique insuffisante. Wanklyn B M et al. (J. Cryst. Growth, 1984, 346-350) décrivent un procédé de croissance de monocristaux de ThO₂ et de CeO₂ de taille améliorée dans un solvant à base de plomb (solvant constitué d'un mélange de Li₂CO₃, B₂O₃, WO₃ et PbF₂). Guyot Y et al. J. Cryst. Growth, 1996, 127-136 décrivent les propriétés de luminescence de monocristaux de Y₂O₃ dopés par des ions Pr³⁺ ou Tm³⁺ ou co-dopés par des ions Yb³⁺, Tb³⁺ ou Ho³⁺ et leur utilisation dans le domaine de l'optique, notamment pour des applications laser. Les cristaux sont obtenus sous forme de fibres en utilisant une technique de croissance dite « LHPG » pour « Laser Heated Pedestal Growth ».

Il n'existe donc à ce jour aucune méthode permettant d'accéder simplement, et sans utilisation d'un matériel particulier ou de conditions extrêmes de température ou de pression, à des monocristaux de sesquioxydes, cubiques de scandium, d'yttrium ou de terre rare dopés aux ions de terre rare présentant, à composition chimique équivalente, une taille supérieure à celle des monocristaux obtenus selon les procédés de l'art antérieur tout en ayant de très bonnes propriétés optiques.

Les inventeurs se sont donc donné pour but de mettre à disposition une méthode permettant d'accéder à de tels monocristaux.

La présente invention a pour objet un procédé de préparation d'un monocristal massif ou en couche mince constitué d'une matrice d'un sesquioxyde cubique de scandium, d'yttrium et/ou de terre rare dopée par au moins un élément de la série des lanthanides, ledit monocristal répondant à la formule (I) suivante :

R¹₂O₃:R² (I)

dans laquelle :
- R¹ est au moins un métal de valence III choisi parmi le scandium, l'yttrium et les éléments de la série des lanthanides, c'est-à-dire parmi les éléments dont le numéro atomique va de 57 (lanthane) à 71 (lutétium) selon la classification périodique des éléments ;
- R² est au moins un élément choisi dans la série des lanthanides ;
ledit procédé étant caractérisé en ce qu'il est réalisé dans un creuset inerte chimiquement et qu'il comprend les étapes suivantes consistant à :
1) préparer, un mélange pulvérulent (MP1) comprenant au moins:
   - un soluté constitué d'un mélange mécanique d'au moins un sesquioxyde de formule (IIa) suivante en un pourcentage molaire (1-x) et d'au moins un sesquioxyde de formule (IIb) suivante en un pourcentage molaire (x) :

      (R'¹₂O₃)₁₋ₓ (IIa) + (R'²₂O₃)ₓ, (IIb)

      dans lesquelles R'¹ est identique à R¹, R'² est identique à R² et 0 < x ≤ 25% molaire, ledit soluté étant présent au sein du mélange MP1 en une quantité z telle que 5 < z ≤ 30 % molaire,
   - un solvant de synthèse de formule (III) suivante :

      [Li₆(R"¹_{1-x'}R"²_{x'})(BO₃)₃] (III)

      dans laquelle :
      - R"¹ et R"² sont respectivement identiques à R¹ et à R² et x' = x ;
2) porter le mélange pulvérulent MP1 obtenu ci-dessus à l'étape 1), à une température T_{MP1} au moins égale à la température de fusion (T_{F}) dudit mélange et ≤ 1250°C, pour entraîner la dissolution du soluté dans le solvant de formule (III) et obtenir une solution liquide dudit soluté dans le solvant de formule (III) ;
3) maintenir la température de la solution liquide à la température T_{MP1} pendant une durée d'au moins 6 heures, sous agitation au moyen d'un support solide soumis à une rotation autour d'un axe vertical ;
4) le refroidissement contrôlé, de la solution liquide depuis la température T_{MP1} jusqu'à une température T_{Exp} comprise entre la température de saturation (T_{Sat}) de la solution liquide et la température de sursaturation critique (TC_{Sur}) de la solution liquide ou de la prise en masse de la solution, pour engendrer la cristallisation contrôlée du sesquioxyde de formule (I) attendu sur ledit support solide immergé dans ladite solution liquide et soumis à une rotation autour d'un axe vertical, ledit refroidissement étant opéré à une vitesse maximale de 1°C.h⁻¹;
5) le retrait du support solide de la solution liquide puis le refroidissement contrôlé du sesquioxyde de formule (I) cristallisé sur le support solide depuis la température T_{Exp} jusqu'à la température ambiante, à une vitesse maximale de 50°C/h⁻¹.

Au sens de la présente invention, le terme « identique » utilisé pour qualifier les radicaux R'¹, R"¹, R'² et R"², en référence à R¹ et R² signifie que R'¹ et R"¹ représentent le même élément que R¹ et que R'² et R"² représentent le même élément que R². Ainsi, et à titre d'exemple lorsque R¹ est l'yttrium (Y), R'¹ = R"¹ = Y, et lorsque R² est l'ytterbium (Yb), R'² = R"² = Yb.

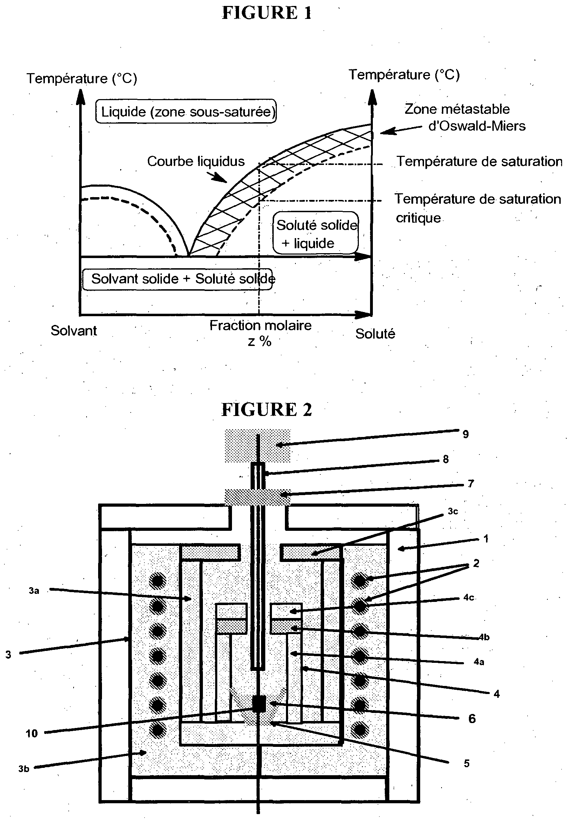

On entend par température de saturation, la température pour laquelle la limite de solubilité du soluté dans la solution est atteinte (équilibre de solubilité). A cette température, et au-delà d'une certaine quantité de soluté déjà introduit et dissous en solution, le soluté additionel peut précipiter sous forme solide. La température de saturation dépend de la fraction molaire « z » du soluté dans la solution. L'équilibre de solubilité en fonction de la fraction molaire du soluté dans la solution est alors décrit par la courbe liquidus dans un diagramme de phase Solvant-Soluté ainsi que cela apparait sur la figure 1 annexée.

La température de sursaturation critique est la température pour laquelle la précipitation du soluté intervient spontanément. En dessous de cette limite, qui est également fonction de la fraction molaire « z » du soluté dans la solution, la cristallisation du soluté ne peut pas être contrôlée et s'effectue de façon spontannée.

La température de sursaturation (T_{Sur}) est une température inférieure à la température de saturation et supérieure à la température de sursaturation critique. Elle correspond à une plage de températures dans laquelle le soluté se trouve dans un état métastable lui permettant de cristalliser de façon contrôlée sans qu'il y ait précipitation. La région thermodynamiquement métastable est comprise entre la température de saturation et la température de sursaturation critique ; elle est fonction de la fraction molaire « z » du soluté dans la solution, et est dénomée « Région d'Oswald-Miers ». (voir figure 1 annexée).

Selon l'invention, T_{Exp} correspond donc à la température « expérimentale » à laquelle on réalise la cristallisation controlée du sesquioxyde de formule (I) ; comme indiquée ci-dessus, cette température est comprise entre la température de saturation (T_{Sat}) de la solution liquide et la température de sursaturation critique (TC_{Sur}) de la solution liquide ou de la prise en masse de la solution ; pour un soluté donné, cette température est comprise dans la région d'Oswald-Miers.

Ces définitions se retrouvent dans l'ouvrage D. Elwell. H. J. Scheel. Crystal Growth from High-Temperature Solutions. Academic Press 1975, chapitre 4 (pp 138-201) et chapitre 7 (pp 278-432).

Toujours selon l'invention, on entend par « couche mince » une couche dont l'épaisseur varie de 1 à 500 µm et de préférence de 1 à 100 µm.

Par rapport aux procédés de l'art antérieur, le procédé conforme à la présente invention présente les avantages suivants :
- le point de fusion du solvant de synthèse de formule (III) est de l'ordre de 860°C, environ. Cela en fait un fondant satisfaisant, faiblement volatile et chimiquement inerte sous différents types d'atmosphère (réductrice, air, oxydante) ;
- grâce à l'utilisation du solvant de synthèse de formule (III), la croissance des monocristaux de formule (I) peut être réalisée à basse température (entre 1000 et 1200°C) dans des conditions faciles à mettre en oeuvre d'un point de vue industriel (travail possible aussi bien à pression atmosphérique que sous pression), alors que les procédés les plus couramment utilisés impliquent des conditions thermodynamiques extrêmes : très hautes températures, très hautes pressions ;

- les ions trivalents (Sc, Y, terres rares) constitutifs du solvant de synthèse de formule (III) sont les mêmes que ceux des sesquioxydes de formule (IIa) et (IIb) «R'¹₂O₃) et (R'²₂O₃)), et les autres ions (Li⁺ et BO₃³⁻) du solvant de synthèse ne se dissolvent pas dans les sesquioxydes de formule (IIa) et (IIb), ce qui conduit à l'obtention de monocristaux ayant une grande qualité cristalline, notamment parce qu'ils ne comportent pas de groupement OH ;
- le solvant de synthèse de formule (III), également dénommé « flux », présente l'avantage de ne pas être corrosif à haute température (dans la gamme de température utilisée selon le procédé conforme à l'invention) avec son environnement ;
- la vitesse de croissance des monocristaux est au moins équivalente à celle observée en mettant en oeuvre un procédé de synthèse par voie hydrothermale ;
- les températures relativement modérées (1000 à 1200°C environ) de cristallisation atteintes grâce à l'utilisation de ce solvant de formule (III) permettent d'envisager la stabilisation dans le degré d'oxydation (+3) de certains ions terre rare facilement réductibles au degré d'oxydation (+2) comme l'europium (Eu), l'ytterbium (Yb), le samarium (Sm) et le thulium (Tm) par exemple ;
- le procédé de cristallogenèse est peu coûteux à mettre en oeuvre, sans problème spécifique de sécurité, il est aussi bien adapté pour la croissance de cristaux massifs (technique du flux conventionnelle) que celle de couches minces par exemple par épitaxie en phase liquide (LPE pour « Liquid Phase Épitaxy ») lorsque que le support est un sesquioxyde de terre rare moliocristallin orienté ou polycristallin ;
- il conduit à des monocristaux ayant une bonne qualité cristalline (pas de lacunes d'oxygène, concentration en dislocations plus faible) ne nécessitant pas de traitements thermiques post croissance (recuit) ;
- le dopage est réalisé de façon aisée (même(s) ion(s) dopant(s) que le(s) cation(s) constitutif(s) de la matrice oxyde du monocristal de formule (I)) ;
- le procédé conduit à des monocristaux pouvant atteindre une taille centimétrique.

Dans la formule (I) ci-dessus, il est indiqué que R¹ représente au moins un métal de valence III. Cela signifie que R¹ peut être soit un élément unique choisi parmi le scandium, l'yttrium et les éléments de la série des lanthanides, soit une combinaison d'au moins 2 de ces éléments telle que par exemple une combinaison Y/Gd, Gd/La, Y/Lu, Gd/Lu, La/Lu, Y/La, Y/Sc, Gd/Sc, ou Lu/Sc. Le cristal de formule (I) est dans ce cas ce qu'il est convenu d'appeler une solution solide dopée par au moins un ion de terre rare.

De la même manière, dans la formule (I) ci-dessus, il est indiqué que R² représente au moins un élément choisi dans la série des lanthanides. Cela signifie que R² peut être soit un élément unique soit une combinaison d'au moins 2 de ces éléments telle que par exemple une combinaison Yb/Pr, Yb/Tm, Yb/Tb, Yb/Ho, Er/Yb, Tm/Tb, ou Tm/Ho, on parle alors de codopage ou de cristal codopé.

Selon une forme de réalisation préférée de l'invention, R¹ est choisi parmi les éléments Y, Gd, Sc et Lu et les combinaisons d'éléments Y/Gd, Y/Sc, Gd/Sc, Lu/Sc, Gd/La, Gd/Lu et Y/Lu.

Egalement selon une forme de réalisation préférée de l'invention, R² est choisi parmi les éléments Yb, Tm, Er, Pr, Tb, Nd, Ce, Ho, Eu, Sm et Dy et les combinaisons d'éléments Yb/Tm, Yb/Pr, Tm/Ho, Er/Yb, Yb/Tb, Yb/Ho et Tm/Tb.

Selon une forme de réalisation préférée de l'invention, ledit procédé est mis en oeuvre pour la préparation de sesquioxydes de formule (I) choisis parmi Y₂O₃:Yb ; Y₂O₃:Pr ; Y₂O₃:Eu, Y₂O₃:Nd ; Y₂O₃:Tm ; Gd₂O₃:Yb ; Gd₂O₃:Pr ; Gd₂O₃:Eu ; Gd₂O₃:Nd ; Gd₂O₃:Tm ; Lu₂O₃:Yb ; Lu₂O₃:Pr ; Lu₂O₃:Eu ; Lu₂O₃:Nd ; Lu₂O₃:Tm; (Y,Gd)₂O₃:Yb ; (Y,Gd)₂O₃:Pr; (Y,Gd)₂O₃:Eu; (Y,Gd)₂O₃:Nd; (Y,La)₂O₃:Pr ; (Gd,La)₂O₃:Pr ; (Gd,La)₂O₃:Yb ; (Gd,La)₂O₃:Eu ; (Gd,La)₂O₃:Nd ; (Y,La)₂O₃:Yb; Y₂O₃:Er:Yb; Y₂O₃:Pu:Yb ; Gd₂O₃:Er:Yb ; Gd₂O₃:Pr:Yb; Gd₂O₃:Tm:Yb ; Lu₂O₃:Tm:Yb; Y₂O₃:Tm:Ho ; Y₂O₃:Tm:Yb, Y₂O₃:Tm:Tb, Sc₂O₃:Eu, (Y,Lu)₂O₃:Eu et (Gd,Lu)₂O₃:Eu.

Au sens de la présente invention, on appelle « soluté », le mélange mécanique constitué d'au moins un sesquioxyde de formule (IIa) constitutif de la matrice et d'au moins un sesquioxyde de formule (IIb) contenant l'ion (ou les ions) dopant(s).

Ainsi que cela a été défini précédemment le soluté est présent en une quantité z telle que 5 < z ≤ 30 % molaire du mélange MP1. Cette quantité correspond à la quantité maximale de soluté cristallisable sous forme monocristalline dans le solvant de formule (III) dans une gamme de température inférieures à 1200°C.

Selon une forme de réalisation préférée de l'invention, la quantité z de soluté présente au sein du mélange pulvérulent MP1 est > 10 % molaire et ≤ 30 % molaire, et encore plus préférentiellement 15 ≤ z ≤ 20 % molaire.

Selon une forme également préférée de l'invention, 0 < x = x' ≤ 5 % molaire.

Lors de l'étape 2), la température T_{MP1} est de préférence de 1200°C à 1250°C et la vitesse à laquelle le mélange MP1 est porté à la température T_{MP1} est de préférence de l'ordre de 120°C.h⁻¹.

Lors de l'étape 4), la température TC_{Sur} est de préférence de l'ordre de 1000°C environ et le refroidissement contrôlé de la solution liquide depuis la température T-MP1 jusqu'à une température T_{Exp} est de préférence réalisé à une vitesse de 0,1 à 1°C.h⁻¹.

Selon une forme de réalisation particulière du procédé, l'étape 4) de refroidissement contrôlé peut être réalisée en effectuant un tirage du cristal, c'est-à-dire en faisant remonter lentement le support solide, toujours sous rotation, selon un mouvement vertical. Ce tirage permet de privilégier une direction de croissance donnée selon une famille de plans bien déterminée dans le but de conduire à un monocristal répondant aux propriétés physiques recherchées pour celui-ci en fonction de l'application envisagée. Dans ce cas, le tirage peut être effectué à une vitesse de tirage (V_{T}) telle que 0,01 ≤ V_{T} ≤ 0,1 mm.h⁻¹.

Selon une forme de réalisation préférée de l'invention, l'étape 4) est réalisée sans tirage du cristal (V_{T} = 0 mm.h⁻¹).

Le soluté utilisé à l'étape 1) du procédé conforme à l'invention n'est pas un produit commercial. Il peut être préparé par simple mélange et broyage de (1-x) % molaire d'au moins un sesquioxyde commercial de formule (IIa) suivante, (matrice) :

R'¹₂O₃ (IIa)

dans laquelle R'¹ est un métal de valence III choisi parmi le scandium, l'yttrium et lés éléments de la série des lanthanides,
et de x % molaire d'au moins un sesquioxyde commercial de formule (IIb) suivante, (oxyde dopant) :

   R'²₂O₃ (IIb)

   dans laquelle R'² est un élément choisi dans la série des lanthanides.

Les différentes étapes du procédé conforme à l'invention, ainsi que les sous-étapes i) à iii) de l'étape 1) le cas échéant, sont réalisées dans un creuset chimiquement inerte vis-à-vis des espèces qu'il contient. Un tel creuset peut par exemple être choisi parmi les creusets de platine, d'iridium ou de carbone vitreux.

Lorsqu'un creuset de platine (uniquement dans ce cas) est utilisé, les différentes étapes du procédé peuvent être réalisées à l'air (atmosphère ambiante) sauf lorsque R¹ et/ou R² désigne le cérium (Ce), alors les étapes du procédé sont de préférence réalisées sous atmosphère neutre ou réductrice, par exemple sous argon à 5 % en volume d'hydrogène. Lorsqu'un creuset d'iridium ou de carbone vitreux est utilisé, les étapes du procédé sont de préférence réalisées sous atmosphère neutre, par exemple sous argon, mais peuvent néanmoins être réalisées sous atmosphère réductrice bien que cela ne soit pas préféré sauf avec le cérium.

Le support solide de cristallisation est de préférence constitué d'une spatule en platine ou d'un fil de platine fixés à une canne d'alumine ou bien encore d'un germe cristallin orienté fixé à un fil de platine lui-même suspendu à une canne d'alumine.

Selon une forme de réalisation préférée, le support solide de cristallisation est une spatule de platine en forme de pelle, de fil platine (diamètre de l'ordre du millimètre) ou de « T » inversé en platine (dans ce cas la barre horizontale du « T » est parallèle au fond du creuset).

Lorsque la croissance du monocristal de formule (I) est réalisée en utilisant comme support solide, un germe monocristallin orienté ou polycristallin, celui-ci est alors de la même nature chimique et/ou structurale que le soluté que l'on veut faire cristalliser (par exemple un sesquioxyde de terre). Le germe est alors immergé dans la solution liquide afin que la croissance par épitaxie phase liquide (LPE) du soluté puisse se réaliser sur ledit germe, ce qui est aussi le cas lors de l'utilisation des objets platine mentionnés ci-dessus. Lorsque la croissance est réalisée par LPE, le monocristal de formule (I) est obtenu sous la forme de couche mince.

Les différentes étapes du procédé nécessitant un traitement thermique sans agitation (étapes 2), et sous-étapes ii) de l'étape 1)) sont de préférence réalisées dans un four tubulaire vertical ou dans un four à moufle.

Les différentes étapes du procédé nécessitant un traitement thermique sous agitation (étapes 3) et 4)), sont de préférence réalisées dans un four tubulaire vertical équipé d'une spatule d'homogénéisation et de contre sédimentation de la solution liquide et pouvant servir de support de cristallisation, ladite spatule étant solidaire d'un système mécanique de rotation/translation/pesée *via* le support solide de cristallisation (germe ou fil de platine ou spatule platine) fixé à une canne en alumine elle-même reliée au système de rotation/tirage/pesée.

L'étape 5) du procédé est de préférence réalisée dans le four tubulaire vertical sans agitation.

Lors des étapes 3) et 4), et 5), la vitesse de rotation du support solide varie de préférence de 20 à 50 tours/min, et encore plus particulièrement de 20 à 35 tours/min lors des étapes 4) et 5) de refroidissement contrôlé (cristallisation).

Selon une forme de réalisation préférée du procédé de l'invention, le refroidissement de l'étape 4) est effectué à une vitesse de 0,5°C.h⁻¹ depuis la température T_{MP1} jusqu'à une température TC_{Sur} de 1000°C, après extraction du support en dehors du liquide et positionnement de celui-ci au dessus de la solution liquide, puis la température de 1000°C est maintenue pendant une durée de moins de 1 heure (thermalisation) avant de procéder au refroidissement mentionné à l'étape 5). Dans ce cas, le refroidissement de l'étape 5) est de préférence réalisé à une vitesse inférieure à 50°C.h⁻¹ environ.

Selon une autre forme de réalisation préférée du procédé de l'invention, le refroidissement de l'étape 4) est un refroidissement en « dents de scie », c'est-à-dire un traitement thermique comportant une alternance d'étapes de refroidissement et d'étapes de remontée en température dans lequel l'amplitude de chaque étape de remontée en température est inférieure à l'amplitude de l'étape de refroidissement qui la précède. Selon une forme de réalisation particulière de réalisation, le refroidissement de l'étape 4) est effectué selon le traitement thermique suivant :
i) refroidissement de la solution liquide depuis la température T_{MP1} jusqu'à 1150°C à une vitesse de 1°C.h⁻¹,
ii) remontée en température de 1150°C à 1180°C à une vitesse de 120°C.h⁻¹,
iii) refroidissement de 1180°C, à 1100°C à une vitesse de 0,7°C.h⁻¹,
iv) remontée en température de 1100°C à 1150°C à une vitesse de 120°C.h⁻¹;
v) refroidissement de 1150°C à 1000°C (TC_{Sat}) à une vitesse de 0,5°C.h⁻¹.

Dans ce cas, le refroidissement de l'étape 5) est de préférence réalisé à une vitesse de 50°C.h⁻¹ environ.

La réalisation de l'étape 4) selon un tel traitement thermique en « dents de scie » présente l'avantage de limiter la nucléation hétérogène multiple sur le support solide (germe, spatule ou fil platine) et facilite donc l'obtention d'un seul monocristal de bonne qualité.

Du fait de leurs très bonnes qualités cristallines et de leur taille importante, les sesquioxydes monocristallins de formule (I) obtenus selon le procédé conforme à la présente invention peuvent avantageusement être utilisés dans le domaine de l'optique.

L'invention a également pour objet l'utilisation d'un sesquioxyde monocristallin de formule (I) telle que définie précédemment et obtenu selon le procédé conforme à la présente invention, pour des applications optiques, pour la fabrication de matériaux pour le refroidissement optique.

La présente invention est illustrée par les exemples de réalisation suivants, auxquels elle n'est cependant pas limitée.

### EXEMPLES

Les matières premières utilisées dans ces exemples sont des poudres de pureté 99,999 %.

Avant leur utilisation, les poudres d'oxyde d'yttrium, d'oxyde de gadolinium et d'oxyde de lutétium ont été préalablement chauffées séparément afin d'obtenir des poudres parfaitement déshydratées, selon le traitement thermique suivant :
1) rampe de 180°C.h⁻¹ jusqu'à 500°C puis palier de 12 h ;
2) rampe de 180°C.h⁻¹ jusqu'à 1000°C puis palier de 12 h ;
3) refroidissement jusqu'à température ambiante avec une vitesse de refroidissement de 180°C.h⁻¹.

Ce traitement thermique a été réalisé dans un creuset en platine sous atmosphère ambiante (air).

Les poudres déshydratées ont alors ensuite été engagées dans les synthèses cristallines dans l'heure qui a suivi la fin du traitement thermique mentionné ci-dessus afin d'éviter toute reprise d'humidité.

Les autres poudres ont été utilisées telles que reçues du fabricant.

Les réactions de synthèse des poudres de soluté et de solvant de synthèse de formule (III) peuvent être réalisées simultanément dans le même creuset platine après mélange intime et broyage préalable de celles-ci entre elles.

### EXEMPLE 1

### Cristallogenèse de monocristaux de Y₂O₃ dopés à 5% (molaire) par de l'ytterbium

Dans cet exemple, on a préparé des sesquioxydes cubiques monocristallins d'yttrium dopés à l'ytterbium : Y₂O₃ :Yb³⁺, en utilisant [Li₆(Y_{0,95}Yb_{0,05})(BO₃)₃] comme solvant de synthèse.

### 1) Première étape : Préparation d'un soluté constitué d'un mélange mécanique de sesquioxyde d'yttrium et de sesquioxyde d'ytterbium :

La préparation du soluté a été réalisée en mélangeant de façon mécanique 95 % molaire de Y₂O₃ et 5 % molaire de Yb₂O₃.

Les poudres commerciales d'Y₂O₃ et Yb₂O₃ ont été mélangées selon les proportions stoechiométriques indiquées ci-dessus, puis broyées intimement dans un mortier afin d'obtenir une granulométrie la plus fine et un mélange mécanique le plus homogène possibles.

### 2) Deuxième étape : Préparation du solvant de synthèse [Li₆(Y_{0,95}Yb_{0,05})(BO₃)₃]

La synthèse du solvant a été effectuée selon la réaction 1 suivante :

6 Li₂CO₃ + 6 H₃BO₃ + 0,95 Y₂O₃ + 0,05 Yb₂O₃ → 2 [Li₆(Y_{0,95}Yb_{0,05})(BO₃)₃] + 9 H₂O + 6 CO₂ (Réaction 1)

Les poudres commerciales de Li₂CO₃, H₃BO₃, Y₂O₃ et Yb₂O₃ ont été mélangées selon les proportions stoechiométriques indiquées par la réaction 1 ci-dessus, puis broyées intimement dans un mortier afin d'obtenir une granulométrie la plus fine et un mélange mécanique le plus homogène possibles. Le mélange a ensuite été chauffé dans un creuset en platine sous une atmosphère d'air selon le traitement thermique suivant :
1) rampe de 180°C.h⁻¹ jusqu'à 450°C puis palier de 12 h ;
2) rampe de 180°C.h⁻¹ jusqu'à 750 °C puis palier de 12 h ;
3) refroidissement jusqu'à température ambiante avec une vitesse de refroidissement de 180°C.h⁻¹.

Le solvant de synthèse [L₁₆(Y_{0,95}Yb_{0,05})(BO₃)₃] ainsi obtenu a ensuite été broyé à l'aide d'un mortier et d'un pilon en Agate.

### 3) Troisième étape : Cristallogenèse des monocristaux de Y₂O₃:Yb³⁺

88,199 g (80,2 % molaire) de solvant de synthèse [Li₆(Y_{0,95}Yb_{0,05})(BO₃)₃] obtenu ci-dessus à l'étape 2) et 16,369 g (19,8 % molaire) du mélange mécanique d'oxydes préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La mise en fusion de la solution a ensuite été effectuée sous air, dans un four tubulaire vertical, en appliquant tout d'abord une rampe de montée en température de 180°C.h⁻¹ jusqu'à 1200°C.

Le four tubulaire vertical utilisé dans cet exemple, et dans les exemples qui suivent est représenté sur la figure 2 annexée. Il comprend une enceinte en acier inoxydable (1) refroidie par eau, dans laquelle sont disposés des éléments chauffants (2) et une enceinte interne (3) en matériau réfractaire constituée d'un tube en alumine (3a), de laine de silice et de Fibrothal® (3b) et d'une rondelle d'alumine (3c). L'enceinte interne (3) renferme un réflecteur thermique (4) disposé autour d'un creuset (5) contenant le mélange réactionnel (solution) (6) en fusion, ledit réflecteur thermique (4) étant constitué d'un tube d'alumine (4a) support du réflecteur (4) surmonté d'une rondelle de platine (4b) elle-même surmontée d'une rondelle d'alumine (4c). Sur sa partie supérieure, l'enceinte (1) est munie d'un passage étanche (7) garantissant l'atmosphère de croissance dans l'enceinte du four, par lequel passe une canne (8) en alumine solidaire d'un système mécanique de rotation/translation et d'un dispositif de pesée (balance ayant une précision de 10⁻³ g) (9) et comportant à son extrémité un support solide d'homogénéisation et de contre-sédimentation du soluté (10) par agitation du soluté dans le solvant pour la croissance du monocristal, ledit support (10) étant immergé dans le mélange réactionnel (6) contenu dans le creuset (5).

Le support (10) peut être constitué d'une spatule en platine ou d'un fil de platine fixés à une canne d'alumine ou bien encore d'un germe cristallin orienté fixé à un fil de platine lui-même suspendu à une canne d'alumine.

Dans cet exemple, le support solide (10) qui a été utilisé était une spatule de platine en forme de T inversé.

Les gradients thermiques dans le four (gradients radial et longitudinal) sont de l'ordre de 1°C.cm⁻¹ de sorte que la température minimale du mélange réactionnel se situe au centre et à la surface du mélange réactionnel.

Le réflecteur thermique (4), muni de la rondelle de platine (épaisseur > 1 mm) (4b) doublée d'une rondelle d'alumine (épaisseur > 2 mm) (4c), permet de diminuer les gradients thermiques. La température au sein du mélange réactionnel est ainsi homogénéisée.

Après thermalisation, la spatule a été immergée par translation suivant l'axe du four (1) et du creuset (5) dans le mélange réactionnel jusqu'à une hauteur de 1 mm à partir du fond du creuset de façon à ce que seul le platine constituant la spatule (10) soit en contact avec le mélange réactionnel fondu et que l'extrémité de la canne (8) en alumine (point d'attache entre la spatule en platine et la canne) soit au moins à plus de 1 cm de la surface du mélange réactionnel.

Une agitation par rotation autour de l'axe de la canne, de l'ordre de 30 tours/mn a été effectuée pendant 4 heures à 1200°C dans le but de bien homogénéiser les espèces dissoutes (soluté) dans le flux et d'éviter leur sédimentation le cas échéant.

La croissance a été effectuée sur la spatule (point froid). Ce support a été immergé à 1200°C par translation dans le mélange réactionnel proche de la surface au centre du creuset. Compte tenu de la viscosité importante du bain fondu, une agitation suffisante, de l'ordre de 20 tr/mn ou plus, s'est avérée nécessaire pour maintenir dissoutes les espèces dans toute la phase liquide et atténuer les effets de sédimentation du soluté.

La croissance cristalline a été effectuée selon le programme de traitement thermique suivant :
- refroidissement lent à une vitesse de 0,5°C.h⁻¹ de 1200°C à 1035°C,
- pas de tirage depuis la solution,
- extraction de la spatule au-dessus du bain fondu,
- refroidissement jusqu'à température ambiante à raison de 42°C. h⁻¹.

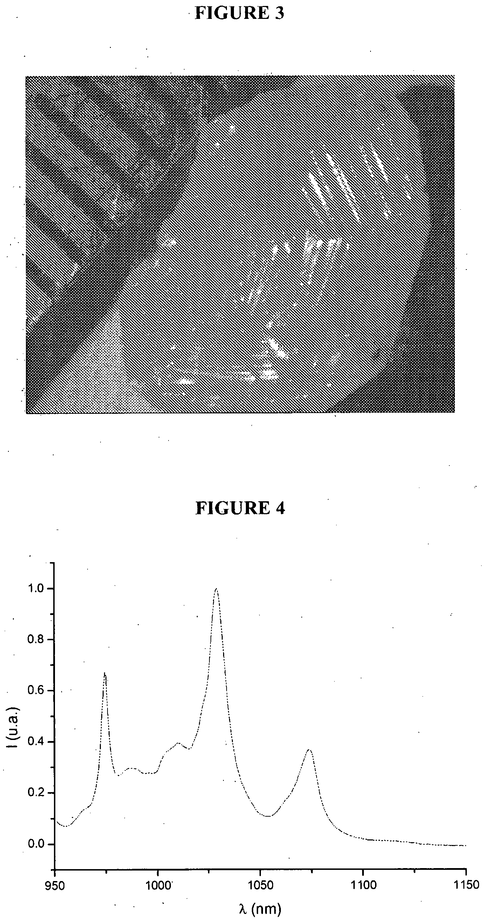

Des monocristaux d'Y₂O₃:Yb³⁺ ont ainsi été obtenus la photographie de l'un d'entre eux est donnée par la figure 3 annexée (grossissement x 20). Sur cette figure, un cristal d'Y₂O₃:Yb³⁺ a été placé en regard d'une règle graduée en millimètres. On constate que le cristal présente une taille de l'ordre du centimètre.

Le cristal d'Y₂O₃:Yb³⁺ ainsi obtenu a été caractérisé par spectrofluorimétrie à température ambiante, à l'aide d'un spectrofluoromètre vendu sous la dénomination commerciale FluoroLog-3 ® par la société HORIBA Jobin Yvon, utilisant comme source d'excitation, une lampe Xe 450 w avec une longueur d'onde d'excitation de 240 nm. Le spectre d'émission est représenté sur la figure 4 annexée sur laquelle l'intensité de l'émission (en unités arbitraires) est fonction de la longueur d'onde λ (en nm).

Le spectre d'émission représenté sur la figure 4 montre l'incorporation de l'ytterbium trivalent dans la matrice de Y₂O₃, (position des raies d'émission entre les niveaux ²F_{5/2} et ²F_{7/2} en accord avec la littérature : Thèse de Doctorat 2006, Université Claude Bernard Lyon I, N° d'ordre: 66-2007, Sana HRAIECH, « Monocristaux cubiques de sesquioxydes Ln2O3 (Ln = Y, Lu et Sc) et de fluorures CaF2 dopés par l'ion terre rare laser Yb3+ : Croissance, caractérisations structurale et spectroscopique »*.*

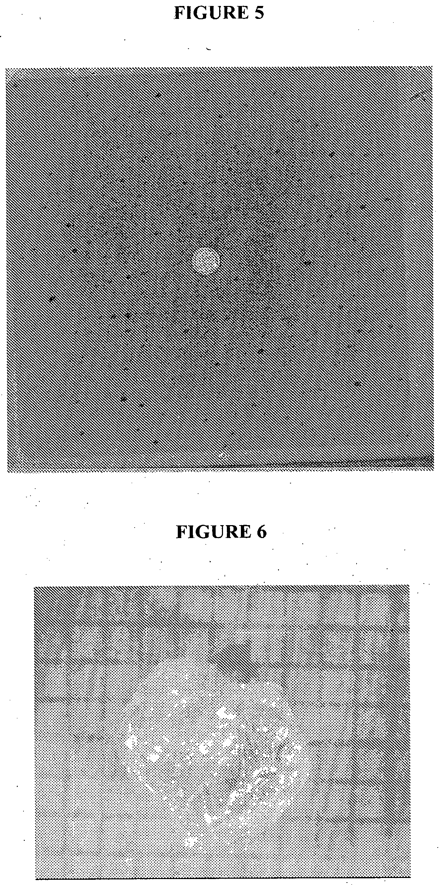

Par ailleurs, le diagramme de diffraction de Laue obtenu par la méthode de Laue [J. J. Rousseau, Cristallographie géométrique et radiocristallographie, Masson, 1995 (ISBN 2-225-84990-0), chap. 11 («Diagrammes de Laue »)] est représenté sur la figure 5 annexée. Brièvement, la méthode de Laue est un procédé de radiocristallographie qui consiste à recueillir le cliché de diffraction d'un faisceau polychromatique de rayons X d'un monocristal fixe.

Les mesures ont été effectuées sur une face naturelle du monocristal d'Y₂O₃:Yb³⁺ orientée (-2-1-1), sur un goniomètre vendu sous la référence GM WS Series X-Ray par la société Delta Technologies International, en utilisant une anti cathode au cuivre et un film photographique de marque Kodak Industrex® - AA400.

Ce diagramme est conforme à la structure théorique attendue et confirme la structure cubique du monocristal d'Y₂O₃:Yb³⁺ obtenu.

### Exemple 2

### Cristallogenèse de monocristaux de Gd₂O₃ dopés à 5% (molaire) par de l'ytterbium

Dans cet exemple, on a préparé des sesquioxydes cubiques monocristallins de gadolinium dopés à l'ytterbium : Gd₂O₃ :Yb³⁺, en utilisant [Li₆(Gd_{0,95}Yb_{0,05})(BO₃)₃] comme solvant de synthèse.

### 1) Première étape : Préparation d'un soluté constitué d'un mélange mécanique d'un sesquioxyde de gadolinium et d'un sesquioxyde d'ytterbium :

La préparation du soluté a été réalisée en mélangeant de façon mécanique 95 % molaire de Gd₂O₃ et 5 % molaire d'Yb₂O₃.

Les poudres commerciales de Gd₂O₃ et d'Yb₂O₃ ont été mélangées selon les proportions stoechiométriques indiquées ci-dessus, puis broyées intimement dans un mortier afin d'obtenir une granulométrie la plus fine et un mélange mécanique le plus homogène possibles.

### 2) Deuxième étape : Préparation du solvant de synthèse [Li₆(Gd_{0,95}Yb_{0,05})(BO₃)₃]

La synthèse du solvant a été effectuée selon la réaction 2 suivante :

6 Li₂CO₃ + 6 H₃BO₃ + 0,95 Gd₂O₃ + 0,05 Yb₂O₃ → 2 [Li₆(Gd_{0,95}Yb_{0,05})(BO₃)₃] + 9H₂O + 6 CO₂ (Réaction 2)

Les poudres commerciales de Li₂CO₃, H₃BO₃, Gd₂O₃ et Yb₂O₃ ont été mélangées selon les proportions stoechiométriques indiquées par la réaction 2 ci-dessus, puis broyées intimement dans un mortier afin d'obtenir une granulométrie la plus fine et un mélange mécanique le plus homogène possibles. Le mélange a ensuite été chauffé dans un creuset en platine sous une atmosphère d'air selon le traitement thermique suivant :
1) rampe de 180°C.h⁻¹ jusqu'à 450°C puis palier de 12 h ;
2) rampe de 180°C.h⁻¹ jusqu'à 750 °C puis palier de 12 h ;
3) refroidissement jusqu'à température ambiante avec une vitesse de refroidissement de 180°C.h⁻¹.

Le solvant de synthèse [Li₆(Gd_{0,95}Yb_{0,05})(BO₃)₃] ainsi obtenu a ensuite été broyé à l'aide d'un mortier et d'un pilon en Agathe.

### 3) Troisième étape : Cristallogenèse des monocristaux de Gd₂O₃ :Yb³⁺

100 g (80 % molaire) de solvant de synthèse [Li₆(Gd_{0,95}Yb_{0,05})(BO₃)₃] obtenu ci-dessus à l'étape 2) et 24,199 g (20 % molaire) du mélange mécanique de sesquioxydes préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La mise en fusion de la solution composée de [Li₆(Gd_{0,95}Yb_{0,05})(BO₃)₃] (solvant de synthèse) et du soluté a ensuite été effectuée dans les mêmes conditions que celles décrites ci-dessus à l'exemple 1.

La cristallisation de Gd₂O₃:Yb³⁺ a été réalisée dans le four décrit ci-dessus à l'exemple 1, selon le protocole décrit à l'exemple 1, en utilisant comme support de cristallisation une spatule de platine en forme de pelle fixée à une canne en alumine, une atmosphère d'air et selon le programme de traitement thermique suivant :
Température de départ : 1200°C
   - rampe de 1°C.h⁻¹ jusqu'à 1100°C,
   - rampe de 180°C.h⁻¹ jusqu'à 1175°C,
   - rampe de 0,7°C.h⁻¹ jusqu'à 1100°C,
   - rampe de 180°C.h⁻¹ jusqu'à 1150°C,
   - rampe de 0,5°C.h⁻¹ jusqu'à 1000°C,
   - pas de tirage depuis la solution,
   - extraction de la spatule au-dessus du bain fondu,
   - refroidissement jusqu'à température ambiante à raison de 44°C. h⁻¹.

On a obtenu des monocristaux de Gd₂O₃:Yb³⁺ dont une photographie est donnée par la figure 6 annexée (grossissement x 20). Sur cette figure, un cristal de Gd₂O₃:Yb³⁺ a été placé sur une feuille de papier millimétré. On constate que le cristal présente une taille supérieure à 5 mm (longueur des cotés).

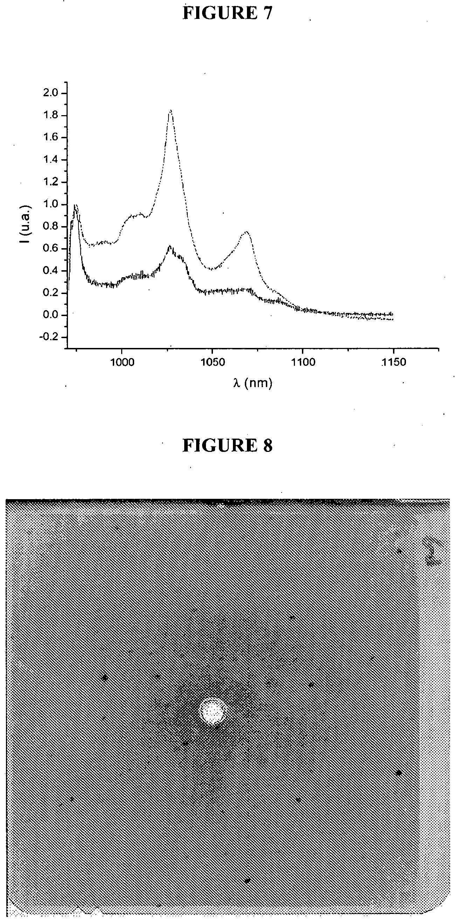

Les spectres d'émission en spectrofluorométrie (effectués sur l'appareil FluoroLog-3 ®, sources d'excitation : lampe Xe 450w à 240 nm (courbe haute) ou diode laser InGaAs à 932 nm (courbe basse)) sont donnés sur la figure 7 annexée, sur laquelle l'intensité de l'émission (en unités arbitraire) est fonction de la longueur d'onde λ (en nm).

Les spectres d'émission représentés sur la figure 7 montrent l'incorporation de l'ytterbium trivalent dans la matrice de Gd₂O₃, (position des raies d'émission entre les niveaux ²F_{5/2} et ²F_{7/2} en accord avec la littérature : Thèse de Doctorat 2006, Sana HRAIECH, *ibid*)*.*

Le diagramme de diffraction de Laue est représenté sur la figure 8 annexée. Les mesures ont été effectuées sur une face naturelle d'un monocristal de Gd₂O₃:Yb³⁺ orientée (-2-1-1).

Ce diagramme est conforme à la structure théorique attendue et confirme la structure cubique du monocristal de Gd₂O₃:Yb³⁺ obtenu.

### Exemple 3

### Cristallogenèse de monocristaux de Lu₂O₃ dopés à 5% (molaire) par de l'ytterbium

Dans cet exemple, on a préparé des sesquioxydes cubiques monocristallins de lutétium dopés à l'ytterbium : Lu₂O₃ :Yb³⁺, en utilisant [Li₆(Lu_{0,95}Yb_{0,05})(BO₃)₃] comme solvant de synthèse.

### 1) Première étape : Préparation d'un soluté constitué d'un mélange de sesquioxyde de lutécium et de sesquioxyde d'ytterbium

La préparation du soluté a été réalisée en mélangeant de façon mécanique 95 % molaire de Lu₂O₃ et 5 % molaire d'Yb₂O₃.

Les poudres commerciales de Lu₂O₃ et d'Yb₂O₃ ont été mélangées selon les proportions stoechiométriques indiquées ci-dessus, puis broyées intimement dans un mortier afin d'obtenir une granulométrie la plus fine et un mélange mécanique le plus homogène possibles.

### 2) Deuxième étape : Préparation du solvant de synthèse [Li₆(Lu_{0,95}Yb_{0,05})(BO₃)₃]

La synthèse du solvant a été effectuée selon la réaction 3 suivante :

6 Li₂CO₃ + 6 H₃BO₃ + 0,95 Lu₂O₃ + 0,05 Yb₂O₃ → 2 [Li₆(Lu_{0,95}Yb_{0,05})(BO₃)₃] + 9 H₂O + 6 CO₂ (Réaction 3)

Les poudres commerciales de Li₂CO₃, H₃BO₃, Lu₂O₃ et Yb₂O₃ ont été mélangées selon les proportions stoechiométriques indiquées par la réaction 3 ci-dessus, puis broyées intimement dans un mortier afin d'obtenir une granulométrie la plus fine et un mélange mécanique le plus homogène possibles. Le mélange a ensuite été chauffé dans un creuset en platine sous une atmosphère d'air selon le traitement thermique suivant :
1) rampe de 180°C.h⁻¹ jusqu'à 450°C puis palier de 12 h ;
2) rampe de 180°C.h⁻¹ jusqu'à 750 °C puis palier de 12 h ;
3) refroidissement jusqu'à température ambiante avec une vitesse de refroidissement de 180°C.h⁻¹.

Le solvant de synthèse [Li₆(Lu_{0,95}Yb_{0,05})(BO₃)₃] ainsi obtenu a ensuite été broyé à l'aide d'un mortier et d'un pilon en Agathe.

### 3) Troisième étape : Cristallogenèse des monocristaux de Lu₂O₃:Yb³⁺

46,365 g (80 % molaire) de solvant de synthèse [Li₆(Lu_{0,95}Yb_{0,05})(BO₃)₃] obtenu ci-dessus à l'étape 2) et 11,733 g (20 % molaire du mélange mécanique des sesquioxydes préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La mise en fusion de la solution composée de [Li₆(Lu_{0,95}Yb_{0,05})(BO₃)₃] (solvant de synthèse) et du soluté a ensuite été effectuée dans les mêmes conditions que celles décrites ci-dessus à l'exemple 1.

La cristallisation de Lu₂O₃:Yb³⁺ a été réalisée dans le four décrit ci-dessus à l'exemple 1, selon le protocole décrit à l'exemple 1, en utilisant comme support de cristallisation une spatule en forme de pelle fixée à une canne d'alumine, une atmosphère d'air et selon le programme de traitement thermique suivant :
Température de départ 1200°C
   - rampe de 0,5°C.h⁻¹ jusqu'à 1000°C,
   - pas de tirage depuis la solution,
   - extraction de la spatule-au-dessus du bain fondu,
   - refroidissement jusqu'à température ambiante à raison de 44°C. h⁻¹.

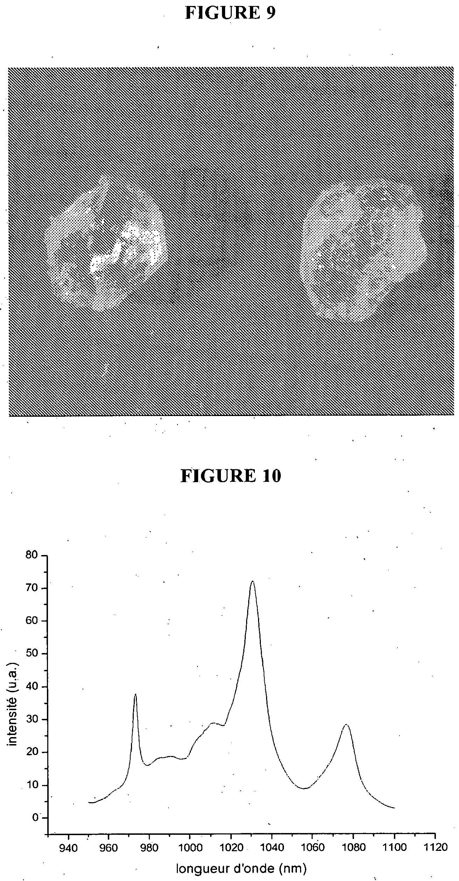

On a obtenu des monocristaux de Lu₂O₃:Yb³⁺ dont une photographie est donnée par là figure 9 annexée (grossissement x 20 environ). Sur cette figure, deux cristaux de Lu₂O₃:Yb³⁺ ont été placés sur une feuille de papier millimétré. On constate que les cristaux présentent une taille supérieure à 3 mm (longueur des cotés).

Le spectre d'émission en spectrofluorométrie (effectués sur l'appareil FluoroLog-3 ®, source d'excitation : lampe Xe 450 w à 240 nm) est donné sur la figure 10 annexée, sur laquelle l'intensité de l'émission (en unités arbitraire) est fonction de la longueur d'onde λ (en nm).

Le spectre d'émission représenté sur la figure 10 montre l'incorporation de l'ytterbium trivalent dans la matrice de Lu₂O₃, (position des raies d'émission entre les niveaux ²F_{5/2} et ²F_{7/2} en accord avec la littérature : Thèse de Doctorat 2006, Sana HRAIECH, *ibid*).

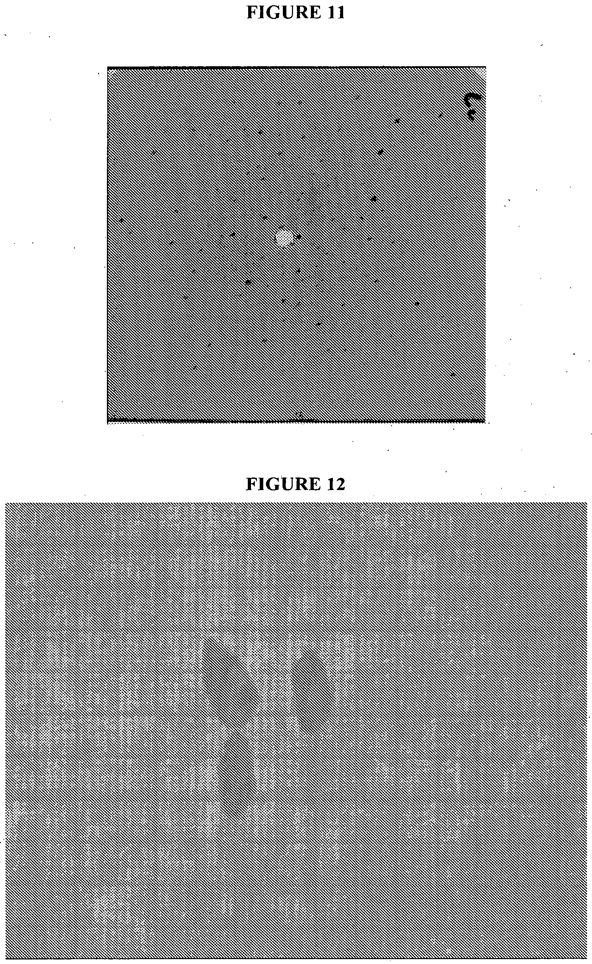

Le diagramme de diffraction de Laue est représenté sur la figure 11 annexée. Les mesures ont été effectuées sur une face naturelle d'un monocristal de Lu₂O₃:Yb³⁺ orientée (-2-1-1).

Ce diagramme est conforme à la structure théorique attendue et confirme la structure cubique du monocristal de Lu₂O₃:Yb³⁺ obtenu.

### Exemple 4

### Cristallogenèse de monocristaux de Gd₂O₃ dopés à 10% (molaire) par de l'ytterbium

Dans cet exemple, on a préparé des sesquioxydes cubiques monocristallins de gadolinium dopés à l'ytterbium : Gd₂O₃ :Yb³⁺, en utilisant [Li₆(Gd_{0,9}Yb_{0,1})(BO₃)₃] comme solvant de synthèse.

### 1) Première étape: Préparation d'un soluté constitué d'un mélange mécanique de sesquioxyde de gadolinium et de sesquioxyde d'ytterbium :

La préparation du soluté été réalisée en mélangeant de façon mécanique 90 % molaire de Gd₂O₃ et 10 % molaire d'Yb₂O₃.

Les poudres commerciales de Gd₂O₃ et d'Yb₂O₃ ont été mélangées selon les proportions stoechiométriques indiquées ci-dessus, puis broyées intimement dans un mortier afin d'obtenir une granulométrie la plus fine et un mélange mécanique le plus homogène possibles.

### 2) Deuxième étape : Préparation du solvant de synthèse [Li₆(Gd_{0,95}Yb_{0,05})(BO₃)₃]

La synthèse du solvant a été effectuée selon la réaction 4 suivante :

6 Li₂CO₃ + 6H₃BO₃ + 0,90 Gd₂O₃ + 0,10 Yb₂O₃ → 2 [Li₆(Gd_{0,9}Yb_{0,1})(BO₃)₃] + 9 H₂O + 6 CO₂ (Réaction 4)

Les poudres commerciales de Li₂CO₃, H₃BO₃, Gd₂O₃ et Yb₂O₃ ont été mélangées selon les proportions stoechiométriques indiquées par la réaction 4 ci-dessus, puis broyées intimement dans un mortier afin d'obtenir une granulométrie la plus fine et un mélange mécanique le plus homogène possibles. Le mélange a ensuite été chauffé dans un creuset en platine sous une atmosphère d'air selon le traitement thermique suivant :
1) rampe de 120 °C.h⁻¹ jusqu'à 505 °C puis palier de 12 h ;
2) rampe de 120 °C.h⁻¹ jusqu'à 800 °C puis palier de 12 h ;
3) rampe de 180 °C.h⁻¹ jusqu'à 1250 °C puis palier de 2 h ;
4) refroidissement jusqu'à température ambiante avec une vitesse de refroidissement de 180 °C.h⁻¹.

Le solvant de synthèse [Li₆(Gd_{0,9}Yb_{0,1})(BO₃)₃] ainsi obtenu a ensuite été broyé à l'aide d'un mortier et d'un pilon en Agathe.

### 3) Troisième étape : Cristallogenèse des monocristaux de Gd₂O₃:Yb³⁺

133,3062 g (80 % molaire) de solvant de synthèse [Li₆(Gd_{0,9}Yb_{0,1})(BO₃)₃] obtenu ci-dessus à l'étape 2) et 32,4 g (20 % molaire) du soluté préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La mise en fusion de la solution composée de [Li₆(Gd_{0,9}Yb_{0,1})(BO₃)₃] (solvant de synthèse) et du soluté a ensuite été effectuée dans les mêmes conditions que celles décrites ci-dessus à l'exemple 1.

La cristallisation de Gd₂O₃:Yb³⁺ a été réalisée dans le four décrit ci-dessus à l'exemple 1, selon le protocole décrit à l'exemple 1, en utilisant comme support de cristallisation une spatule de platine en forme de pelle fixée à une canne en alumine, une atmosphère d'air et selon le programme de traitement thermique suivant :
Température de départ : 20 °C
   - rampe de 136,7 °C.h⁻¹ jusqu'à 1250 °C, puis palier de 1 h
   - rampe de 180 °C.h⁻¹ jusqu'à 1200 °C, puis palier de 1 h
   - rampe de 0,5 °C.h⁻¹ jusqu'à 1100 °C,
   - rampe de 180 °C.h⁻¹ jusqu'à 1150 °C,
   - rampe de 0,3 °C.h⁻¹ jusqu'à 1000 °C,
   - pas de tirage depuis la solution,
   - extraction de la spatule au-dessus du bain fondu à 1000 °C,
   - refroidissement jusqu'à 800 °C à raison de 2 °C. h⁻¹,
   - refroidissement jusqu'à température ambiante à raison de 60 °C. h⁻¹.

On a obtenu des monocristaux de Gd₂O₃:Yb³⁺ dont une photographie est donnée par la figure 12 annexée. Sur cette figure, les cristaux de Gd₂O₃:Yb³⁺ ont été placés sur une feuille de papier millimétré. On constate que les cristaux présentent une taille de l'ordre du centimètre (grande longueur).

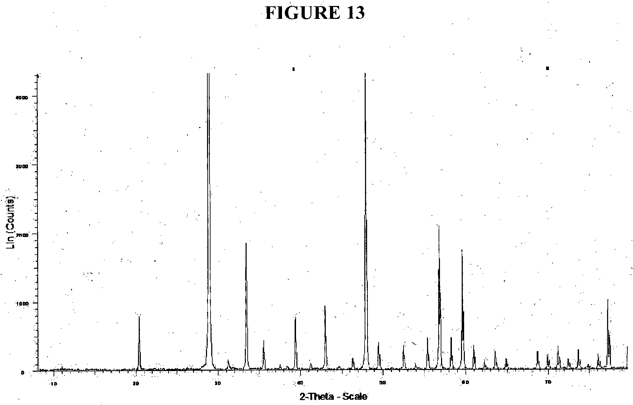

Un cristal a été broyé et la poudre obtenue a été analysée par diffraction des rayons X. L'appareil utilisé est un diffractomètre PANalytical X'Pert MPD en géométrie Bragg-Brentano (θ-θ) CuKalpha (λ = 1,54187 Å). Le diagramme de diffraction sur poudre est représenté sur la figure 13 annexée.

Ce diagramme est conforme à la structure théorique attendue et confirme la structure cubique du monocristal de Gd₂O₃:Yb³⁺ obtenu.

## Revendications

1. Procédé de préparation d'un monocristal massif ou en couche mince constitué d'une matrice d'un sesquioxyde cubique de scandium, d'yttrium et/ou de terre rare dopée par au moins un élément de la série des lanthanides, ledit monocristal répondant à la formule (I) suivante :
R¹₂O₃:R² (I)
dans laquelle :
- R¹ est au moins un métal de valence III choisi parmi le scandium, l'yttrium et les éléments de la série des lanthanides ;
- R² est au moins un élément choisi dans la série des lanthanides ;
ledit procédé étant **caractérisé en ce qu'**il est réalisé dans un creuset inerte chimiquement et qu'il comprend les étapes suivantes consistant à :
1) préparer, un mélange pulvérulent (MP1) comprenant au moins :
- un soluté constitué d'un mélange mécanique d'au moins un sesquioxyde de formule (IIa) suivante en un pourcentage molaire (1-x) et d'au moins un sesquioxyde de formule (IIb) suivante en un pourcentage molaire (x) :
(R'¹₂O₃)₁₋ₓ (IIa) + (R'²₂O₃)ₓ (IIb)
dans lesquelles R'¹ est identique à R¹, R'² est identique à R² et 0 < x ≤ 25 % molaire, ledit soluté étant présent au sein du mélange MP1 en une quantité z telle que 5 < z ≤ 30 % molaire,
- un solvant de synthèse de formule (III) suivante :
Li₆(R"¹_{1-x'}R"²_{x'})(BO₃)₃] (III)
dans laquelle :
- R"¹ et R"² sont respectivement identiques à R¹ et à R² et x' = x ;
2) porter le mélange pulvérulent MP1 obtenu ci-dessus à l'étape 1), à une température T_{MP1} au moins égale à la température de fusion (T_{F}) dudit mélange et ≤ 1250°C, pour entraîner la dissolution du soluté dans le solvant de formule (III) et obtenir une solution liquide dudit soluté dans le solvant de formule (III) ;
3) maintenir la température de la solution liquide à la température T_{MP1} pendant une durée d'au moins 6 heures, sous agitation au moyen d'un support solide soumis à une rotation autour d'un axe vertical ;
4) le refroidissement contrôlé, de la solution liquide depuis la température T_{MP1} jusqu'à une température T_{Exp} comprise entre la température de saturation (T_{Sat}) de la solution liquide et la température de sursaturation critique (TC_{Sur}) de la solution liquide ou de la prise en masse de la solution, pour engendrer la cristallisation contrôlée du sesquioxyde de formule (I) attendu sur ledit support solide immergé dans ladite solution liquide et soumis à une rotation autour d'un axe vertical, ledit refroidissement étant opéré à une vitesse maximale de 1°C.h⁻¹ ;
5) le retrait du support solide de la solution liquide puis le refroidissement contrôlé du sesquioxyde de formule (I) cristallisé sur le support solide depuis la température T_{Exp} jusqu'à la température ambiante, à une vitesse maximale de 50°C/h⁻¹.

2. Procédé selon la revendication 1, **caractérisé en ce que** R¹ est choisi parmi les éléments Y, Gd, Sc et Lu et les combinaisons d'éléments Y/Gd, Y/Sc, Gd/Sc, Lu/Sc, Gd/La, Gd/Lu et Y/Lu.

3. Procédé selon la revendication 1 ou 2, **caractérisé en ce que** R² est choisi parmi les éléments Yb, Tm, Er, Pr, Tb, Nd, Ce, Ho, Eu, Sm et Dy et les combinaisons d'éléments Yb/Tm, Yb/Pr, Tm/Ho, Er/Yb, Yb/Tb, Yb/Ho et Tm/Tb.

4. Procédé selon l'une quelconque des revendications précédentes, **caractérisé en ce qu'**il est mis en oeuvre pour la préparation de sesquioxydes de formule (I) choisis parmi Y₂O₃:Yb ; Y₂O₃:Pr ; Y₂O₃:Eu, Y₂O₃:Nd ; Y₂O₃:Tm ; Gd₂O₃:Yb ; Gd₂O₃:Pr; Gd₂O₃:Eu ; Gd₂O₃:Nd ; Gd₂O₃:Tm; Lu₂O₃:Yb ; Lu₂O₃:Pr ; Lu₂O₃:Eu ; Lu₂O₃:Nd ; Lu₂O₃:Tm ; (Y,Gd)₂O₃:Yb; (Y,Gd)₂O₃:Pr ; (Y,Gd)₂O₃:Eu ; (Y,Gd)₂O₃:Nd ; (Y,La)₂O₃:Pr ; (Gd,La)₂O₃:Pr ; (Gd,La)₂O₃:Yb ; (Gd,La)₂O₃:Eu; (Gd,La)₂O₃:Nd; (Y,La)₂O₃:Yb ; Y₂O₃:Er:Yb ; Y₂O₃:Pr:Yb ; Gd₂O₃:Er:Yb ; Gd₂O₃:Pr:Yb ; Gd₂O₃:Tm:Yb; Lu₂O₃:Tm:Yb ; Y₂O₃:Tm:Ho; Y₂O₃:Tm:Yb, Y₂O₃:Tm:Tb, Sc₂O₃:Eu, (Y,Lu)₂O₃:Eu et (Gd,Lu)₂O₃:Eu.

5. Procédé selon l'une quelconque des revendications précédentes, **caractérisé en ce que** la quantité z de soluté présente au sein du mélange pulvérulent MP1 est > 10 % molaire et ≤ 30 % molaire.

6. Procédé selon l'une quelconque des revendications précédentes, **caractérisé en ce que** 0 < x = x' ≤ 5 % molaire.

7. Procédé selon l'une quelconque des revendications précédentes, **caractérisé en ce que** lors de l'étape 2), la température T_{MP1} est de 1200°C à 1250°C et la vitesse à laquelle le mélange MP1 est porté à la température T_{MP1} est de 120°C.h⁻¹.

8. Procédé selon l'une quelconque des revendications précédentes, **caractérisé en ce que** lors de l'étape 4), la température TC_{Sur} est de 1000°C et le refroidissement contrôlé de la solution liquide depuis la température T_{MP1} jusqu'à une température T_{Exp} est réalisé à une vitesse de 0,1 à 1°C.h⁻¹.

9. Procédé selon l'une quelconque des revendications précédentes, **caractérisé en ce que** le support solide de cristallisation est constitué d'une spatule en platine ou d'un fil de platine fixés à une canne d'alumine ou bien encore d'un germe cristallin orienté fixé à un fil de platine lui-même suspendu à une canne d'alumine.

10. Procédé selon la revendication 9, **caractérisé en ce que** le support solide est un germe monocristallin orienté ou polycristallin de même nature chimique et/ou structurale que le soluté, immergé dans la solution liquide et que la croissance est réalisée par épitaxie en phase liquide.

11. Procédé selon l'une quelconque des revendications précédentes, **caractérisé en ce que** les étapes 3) et 4) sont réalisées dans un four tubulaire vertical équipé d'une spatule d'homogénéisation et de contre sédimentation de la solution liquide et pouvant servir de support de cristallisation, ladite spatule étant solidaire d'un système mécanique de rotation/translation/pesée *via* le support solide de cristallisation fixé à une canne en alumine elle-même reliée au système de rotation/tirage/pesée.

12. Procédé selon l'une quelconque des revendications précédentes, **caractérisé en ce que** lors des étapes 3) et 4), et 5), la vitesse de rotation du support solide varie de 20 à 50 tours/min.

13. Procédé selon la revendication 12, **caractérisé en ce que** la vitesse de rotation du support solide varie de 20 à 35 tours/min lors des étapes 4) et 5) de refroidissement contrôlé.

14. Procédé selon l'une quelconque des revendications précédentes, **caractérisé en ce que** le refroidissement de l'étape 4) est effectué à une vitesse de 0,5°C.h⁻¹ depuis la température T_{MP1} jusqu'à une température TC_{Sur} de 1000°C, après extraction du support en dehors du liquide et positionnement de celui-ci au dessus de la solution liquide, puis la température de 1000°C est maintenue pendant une durée de moins de 1 heure avant de procéder au refroidissement mentionné à l'étape 5).

15. Procédé selon la revendication 14, **caractérisé en ce que** le refroidissement de l'étape 5) est réalisé à une vitesse inférieure à 50°C.h⁻¹.

16. Procédé selon l'une quelconque des revendications 1 à 13, **caractérisé en ce que** le refroidissement de l'étape 4) est un traitement thermique comportant une alternance d'étapes de refroidissement et d'étapes de remontée en température dans lequel l'amplitude de chaque étape de remontée en température est inférieure à l'amplitude de l'étape de refroidissement qui la précède.

17. Procédé selon la revendication 16, **caractérisé en ce que** le refroidissement de l'étape 4) est effectué selon le traitement thermique suivant :
i) refroidissement de la solution liquide depuis la température T_{MP1} jusqu'à 1150°C à une vitesse de 1°C.h⁻¹,
ii) remontée en température de 1150°C à 1180°C à une vitesse de 120°C.h⁻¹,
iii) refroidissement de 1180°C à 1100°C à une vitesse de 0,7°C.h⁻¹,
iv) remontée en température de 1100°C à 1150°C à une vitesse de 120°C.h⁻¹,
v) refroidissement de 1150°C, à 1000°C (TC_{Sur}) à une vitesse de 0,5°C.h⁻¹.

18. Procédé selon la revendication 16 ou 17, **caractérisé en ce que** le refroidissement de l'étape 5) est réalisé à une vitesse de 50°C.h⁻¹.

## Patentansprüche

1. Verfahren zur Herstellung eines massiven Monokristalls oder in Dünnschicht, gebildet aus einer Matrix eines kubischen Scandium-, Yttrium- und/oder Seltene Erde-Sesquioxids, dotiert von mindestens einem Element der Reihe der Lanthanide, wobei das Monokristall der folgenden Formel (I) entspricht:
R¹₂0₃:R² (I)
wobei:
- R¹ mindestens ein Metall mit der Wertigkeit III ist, ausgewählt aus dem Scandium, dem Yttrium und den Elementen der Reihe der Lanthanide,
- R² mindestens ein Element, ausgewählt aus der Reihe der Lanthanide, ist,
wobei das Verfahren **dadurch gekennzeichnet ist, dass** es in einem chemisch inerten Tiegel durchgeführt wird und dass es die folgenden Schritte umfasst, die im bestehen aus:
1) Vorbereiten eines pulverförmigen Gemischs (MP1), umfassend mindestens:
- ein Gelöstes, gebildet aus einem mechanischen Gemisch mindestens eines Sesquioxids der folgenden Formel (IIa) in einem molaren Prozentsatz (1-x) und mindestens eines Sesquioxids der folgendne Formel (IIb) in einem molaren Prozentsatz (x):
(R'¹₂O₃)₁₋ₓ (IIa) + (R'²₂O₃)ₓ (IIb)
wobei R'¹ identisch zu R¹, R'² identisch zu R² und 0 < x ≤ 25 Mol-%, wobei das Gelöste innerhalb des Gemischs MP1 in einer Menge z vorhanden ist, so dass 5 < z ≤ 30 Mol-% ist,
- ein synthetisches Lösungsmittel der folgenden Formel (III):
[Li₆(R"¹_{1-x'}R^{"2}_{x'})(BO₃)₃] (III)
wobei:
- R"¹ und R"² jeweils mit R¹ und mit R² identisch sind und x' = x,
2) Erhitzen des pulverförmigen Gemischs MP1 aus obigem Schritt 1) auf eine Temperatur T_{MP1}, die mindestens gleich der Schmelztemperatur (T_{F}) des Gemischs entspricht und ≤ 1250 °C ist, um das Auflösen des Gelösten in dem Lösungsmittel der Formel (III) zu bewirken und eine flüssige Lösung des Gelösten im Lösungsmittel der Formel (III) zu erhalten,
3) Halten der Temperatur der flüssigen Lösung auf der Temperatur T_{MP1} während einer Dauer von mindestens 6 Stunden, mit Rühren mittels eines festen Trägers, der in eine Rotation um eine vertikale Achse versetzt wird,
4) kontrolliertes Abkühlen der flüssigen Lösung von der Temperatur T_{MP1} auf eine Temperatur T_{Exp} zwischen der Sättigungstemperatur (T_{Sat}) der flüssigen Lösung und der kritischen Übersättigungstemperatur (TC_{Sur}) der flüssigen Lösung oder des Verdickens der Lösung, um die auf dem festen Träger, der in die flüssige Lösung eingetaucht ist und in eine Rotation um eine vertikale Achse versetzt wird, erwartete kontrollierte Kristallisierung des Sesquioxids der Formel (I) hervorzurufen, wobei die Abkühlung mit einer maximalen Geschwindigkeit von 1 °C.h⁻¹ durchgeführt wird,
5) Entfernen des festen Trägers aus der flüssigen Lösung, dann kontrolliertes Abkühlen des auf dem festen Träger kristallisierten Sesquioxids der Formel (I) von der Temperatur T_{Exp} auf Raumtemperatur mit einer maximalen Geschwindigkeit von 50 °C/h⁻¹.

2. Verfahren nach Anspruch 1, **dadurch gekennzeichnet, dass** R¹ aus den Elementen Y, Gd, Se und Lu und den Elementekombinationen Y/Gd, Y/Sc, Gd/Sc, Lu/Se, Gd/La, Gd/Lu und Y/Lu ausgewählt ist.

3. Verfahren nach Anspruch 1 oder 2, **dadurch gekennzeichnet, dass** R² aus den Elementen Yb, Tm, Er, Pr, Tb, Nd, Ce, Ho, Eu, Sm und Dy und den Elementekombinationen Yb/Tm, Yb/Pr, Tm/Ho, Er/Yb, Yb/Tb, Yb/Ho und Tm/Tb ausgewählt ist.

4. Verfahren nach einem der vorangehenden Ansprüche, **dadurch gekennzeichnet, dass** für die Herstellung Sesquioxide der Formel (I) umgesetzt werden, ausgewählt aus Y₂O₃:Yb; Y₂O₃:Pr; Y₂O₃:Eu, Y₂O₃:Nd; Y₂O₃:Tm; Gd₂O₃:Yb; Gd₂O₃:Pr; Gd₂O₃:Eu; Gd₂O₃:Nd; Gd₂O₃:Tm; Lu₂O₃:Yb; Lu₂O₃:Pr; Lu₂O₃:Eu; Lu₂O₃:Nd; Lu₂O₃:Tm; (Y,Gd)₂O₃:Yb; (Y,Gd)₂O₃:Pr; (Y,Gd)₂O₃:Eu; (Y,Gd)₂O₃:Nd; (Y,La)₂O₃:Pr; (Gd,La)₂O₃:Pr; (Gd,La)₂O₃:Yb; (Gd,La)₂O₃:Eu; (Gd,La)₂O₃:Nd; (Y,La)₂O₃:Yb; Y₂O₃:Er:Yb; Y₂O₃:Pr:Yb; Gd₂O₃:Er:Yb; Gd₂O₃:Pr:Yb; Gd₂O₃:Tm:Yb; Lu₂O₃:Tm:Yb; Y₂O₃:Tm:Ho; Y₂O₃:Tm:Yb, Y₂O₃:Tm:Tb, Sc₂O₃:Eu, (Y,Lu)₂O₃:Eu und (Gd,Lu)₂O₃:Eu.

5. Verfahren nach einem der vorangehenden Ansprüche, **dadurch gekennzeichnet, dass** die innerhalb des pulverförmigen Gemischs MP1 vorhandene Gelöstenmenge z > 10 Mol-% und ≤ 30 Mol-% beträgt.

6. Verfahren nach einem der vorangehenden Ansprüche, **dadurch gekennzeichnet, dass** 0 < x = x' ≤ 5 Mol-% ist.

7. Verfahren nach einem der vorangehenden Ansprüche, **dadurch gekennzeichnet, dass** bei Schritt 2) die Temperatur T_{MP1} 1200 °C bis 1250 °C beträgt und die Geschwindigkeit mit welcher das Gemisch MP1 auf die Temperatur T_{MP1} gebracht wird, 120 °C.h⁻¹ beträgt.

8. Verfahren nach einem der vorangehenden Ansprüche, **dadurch gekennzeichnet, dass** bei Schritt 4) die Temperatur TC_{Sur} 1000 °C beträgt und die kontrollierte Abkühlung der flüssigen Lösung von der Temperatur T_{MP1} auf eine Temperatur T_{Exp} mit einer Geschwindigkeit von 0,1 bis 1 °C.h⁻¹ durchgeführt wird.

9. Verfahren nach einem der vorangehenden Ansprüche, **dadurch gekennzeichnet, dass** der feste Kristallisationsträger von einem Platinspatel oder einem Platindraht gebildet ist, die an einem Aluminiumoxidstab befestigt sind oder auch von einem ausgerichteten Kristallkeim, der an einem Platindraht befestigt ist, der selbst an einem Aluminiumoxidstab aufgehängt ist.

10. Verfahren nach Anspruch 9, **dadurch gekennzeichnet, dass** der feste Träger ein ausgerichteter monokristalliner oder polykristalliner Keim derselben chemischen und/oder strukturellen Art wie das Gelöste ist, eingetaucht in die flüssigen Lösung, und dass das Wachstum per Epitaxie in flüssiger Phase erfolgt.

11. Verfahren nach einem der vorangehenden Ansprüche, **dadurch gekennzeichnet, dass** die Schritte 3) und 4) in einem vertikalen rohrförmigen Ofen durchgeführt werden, der mit einem Homogenisierungs- und Gegensedimentierungsspatel der flüssigen Lösung ausgestattet ist und der als Kristallisationsträger dienen kann, wobei der Spatel mit einem mechanischen Rotations-Translations-Wägesystem über den festen Kristallisationsträger fest verbunden ist, befestigt an einem Aluminiumoxidstab, der selbst mit dem Rotations-Translations-Wägesystem verbunden ist.

12. Verfahren nach einem der vorangehenden Ansprüche, **dadurch gekennzeichnet, dass** bei den Schritten 3) und 4) und 5) die Rotationsgeschwindigkeit des festen Trägers von 20 bis 50 U/min schwankt.

13. Verfahren nach Anspruch 12, **dadurch gekennzeichnet, dass** die Rotationsgeschwindigkeit des festen Trägers von 20 bis 35 U/min bei den Schritten 4) und 5) der kontrollierten Abkühlung schwankt.

14. Verfahren nach einem der vorangehenden Ansprüche, **dadurch gekennzeichnet, dass** die Abkühlung von Schritt 4) mit einer Geschwindigkeit von 0,5 °C.h⁻¹ von der Temperatur T_{MP1} auf eine Temperatur TC_{Sur} von 1000 °C durchgeführt wird nach Extraktion des Trägers aus der Flüssigkeit und Positionierung desselben über der flüssigen Lösung, dann wird die Temperatur von 1000 °C während einer Dauer von mindestens 1 Stunde gehalten, bevor die Abkühlung von Schritt 5) durchgeführt wird.

15. Verfahren nach Anspruch 14, **dadurch gekennzeichnet, dass** die Abkühlung von Schritt 5) bei einer Geschwindigkeit unter 50 °C.h⁻¹ durchgeführt wird.

16. Verfahren nach einem der Ansprüche 1 bis 13, **dadurch gekennzeichnet, dass** die Abkühlung von Schritt 4) eine thermische Behandlung ist, die eine abwechselnde Abfolge von Abkühlungsschritten und Temperaturerhöhungsschritten aufweist, wobei die Amplitude jedes Temperaturerhöhungsschritts kleiner als die Amplitude des vorhergehenden Abkühlungsschritts ist.

17. Verfahren nach Anspruch 16, **dadurch gekennzeichnet, dass** die Abkühlung von Schritt 4) gemäß der folgenden thermischen Behandlung durchgeführt wird:
i) Abkühlen der flüssigen Lösung von der Temperatur T_{MP1} auf 1150 °C mit einer Geschwindigkeit von 1 °C.h⁻¹,
ii) Erhöhen der Temperatur von 1150 °C auf 1180 °C mit einer Geschwindigkeit von 120 °C.h⁻¹,
iii) Abkühlen von 1180 °C auf 1100 °C mit einer Geschwindigkeit von 0,7 °C.h⁻¹,
iv) Erhöhen der Temperatur von 1100 °C auf 1150 °C mit einer Geschwindigkeit von 120 °C.h⁻¹,
v) Abkühlen von 1150 °C auf 1000 °C (TC_{Sur}) mit einer Geschwindigkeit von 0,5 °C.h⁻¹.

18. Verfahren nach Anspruch 16 oder 17, **dadurch gekennzeichnet, dass** das Abkühlen von Schritt 5) mit einer Geschwindigkeit von 50 °C.h⁻¹ durchgeführt wird.

## Claims

1. A method for preparing a bulk or thin-layer single crystal consisting of a scandium, yttrium and/or rare earth sesquioxide cubic matrix doped with at least one element from the series of lanthanides, said single crystal fitting the following formula (I):
R¹₂O₃:R² (I)
wherein:
- R¹ is at least one metal of valency III selected from among scandium, yttrium, and the elements from the series of lanthanides;
- R² is at least one element selected from the series of lanthanides;
said method being **characterized in that** it is carried out in a chemically inert crucible and that it comprises the following steps consisting of:
1) preparing a powdery mixture (MP1) comprising at least:
- a solute consisting of a mechanical mixture of at least one sesquioxide of the following formula (IIa) in a molar percentage (1-x) and of at least one sesquioxide of the following formula (IIb) in a molar percentage (x):
(R'¹₂O₃)₁₋ₓ (IIa) + (R'²₂O₃)ₓ (IIb)
wherein R'¹ is identical with R¹, R'² is identical with R² and 0<x≤25% molar, said solute being present within the mixture MP1 in an amount z such that 5<z≤30% molar,
- a synthesis solvent of the following formula (III):
[Li₆(R"¹_{1-x'}R"²_{x'})(BO₃)₃] (III)
wherein:
R"¹ and R"² are respectively identical with R¹ and with R² and x'=x;
2) bringing the powdery mixture MP1 obtained above in step 1), to a temperature T_{MP1} at least equal to the melting temperature (T_{F}) of said mixture and ≤1250°C, for causing dissolution of the solute in the solvent of formula (III) and for obtaining a liquid solution of said solute in the solvent of formula (III);
3) maintaining the temperature of the liquid solution at the temperature T_{MP1} for a period of at least 6 hours, with stirring by means of a solid support subject to rotation around a vertical axis;
4) controlled cooling of the liquid solution from the temperature T_{MP1} up to a temperature T_{Exp} comprised between the saturation temperature (Tₛₐₜ) of the liquid solution and the critical oversaturation temperature (TCₒᵥₑᵣ) of the liquid solution or the bulk setting of the solution, for generating controlled crystallization of the sesquioxide of formula (I) expected on said solid support immersed in said liquid solution and subject to rotation around a vertical axis, said cooling being performed at a maximum rate of 1°C.h⁻¹;
5) withdrawing the solid support from the liquid solution and then controlled cooling of the crystallized sesquioxide of formula (I) on the solid support from the temperature T_{Exp} down to room temperature, a a maximum rate of 50°C.h⁻¹.

2. The method according to claim 1, **characterized in that** R¹ is selected from among the elements Y, Gd, Sc and Lu and the combinations of elements Y/Gd, Y/Sc, Gd/Sc, Lu/Sc, Gd/La, Gd/Lu and Y/Lu.

3. The method according to claim 1 or 2, **characterized in that** R² is selected from among the elements Yb, Tm, Er, Pr, Tb, Nd, Ce, Ho, Eu, Sm and Dy and the combinations of elements Yb/Tm, Yb/Pr, Tm/Ho, Er/Yb, Yb/Tb, Yb/Ho, and Tm/Tb.

4. The method according to any of the preceding claims, **characterized in that** it is applied for preparing sesquioxides of formula (I) selected from among Y₂O₃:Yb; Y₂O₃:Pr; Y₂O₃:Eu; Y₂O₃:Nd; Y₂O₃:Tm; Gd₂O₃:Yb; Gd₂O₃:Pr; Gd₂O₃:Eu; Gd₂O₃:Nd; Gd₂O₃:Tm; Lu₂O₃:Yb; Lu₂O₃:Pr; Lu₂O₃:Eu; Lu₂O₃:Nd; Lu₂O₃:Tm; (Y, Gd)₂O₃:Yb; (Y, Gd)₂O₃:Pr; (Y, Gd)₂O₃:Eu; (Y, Gd)₂O₃:Nd; (Y, La)₂O₃:Pr; (Gd, La)₂O₃:Pr; (Gd, La)₂O₃:Yb; (Gd, La)₂O₃:Eu; (Gd, La)₂O₃:Nd; (Y, La)₂O₃:Yb; Y₂O₃:Er:Yb; Y₂O₃:Pr:Yb; Gd₂O₃:Er:Yb; Gd₂O₃:Pr:Yb; Gd₂O₃:Tm:Yb; Lu₂O₃:Tm:Yb; Y₂O₃:Tm:Ho; Y₂O₃:Tm:Yb; Y₂O₃:Tm:Tb; Sc₂O₃:Eu; (Y,Lu)₂O₃:Eu and (Gd,Lu)₂O₃:Eu.

5. The method according to any of the preceding claims, **characterized in that** the amount z of solute present within the powdery mixture MP1 is >10% molar and ≤30% molar.

6. The method according to any of the preceding claims, **characterized in that** 0<x=x'≤5% molar.

7. The method according to any of the preceding claims, **characterized in that** during step 2), the temperature T_{MP1} is from 1,200°C to 1,250°C and the rate at which the mixture MP1 is brought to the temperature T_{MP1} is 120°C.h⁻¹.

8. The method according to any of the preceding claims, **characterized in that** during step 4), the temperature TCₒᵥₑᵣ is 1,000°C and the controlled cooling of the liquid solution from the temperature T_{MP1} up to T_{Exp} is carried out at a rate from 0.1 to 1°C.h⁻¹,

9. The method according to any of the preceding claims, **characterized in that** the crystallization solid support consists of a platinum spatula or platinum wire attached to an alumina rod or else further an oriented crystalline germ, attached to a platinum wire itself suspended from an alumina rod.

10. The method according to claim 9, **characterized in that** the solid support is an oriented single-crystal or multi-crystal germ of the same chemical or structural nature as the solute, immersed in the liquid solution and that the growth is achieved by liquid phase epitaxy.

11. The method according to any of the preceding claims, **characterized in**
**that**
steps 3) and 4) are carried out in a vertical tubular oven equipped with a homogenization spatula and against sedimentation of the liquid solution and which may be used as a crystallization support, said spatula being secured to a rotation/translation/weighing mechanical system via the crystallization support attached to an alumina rod itself connected to a rotation/drawing/weighing system.

12. The method according to any of the preceding claims, **characterized in that** during steps 3) and 4), and 5), the speed of rotation of the solid support varies from 20 to 50 revolutions per minute.

13. The method according to claim 12, **characterized in that** the speed of rotation of the solid support varies from 20 to 35 revolutions per minute during the controlled cooling steps 4) and 5).

14. The method according to any of the preceding claims, **characterized in that** the cooling of step 4) is carried out at a rate of 0.5°C.h⁻¹ from temperature T_{MP1} up to a temperature TCₒᵥₑᵣ of 1,000°C, after extracting the support from out of the liquid and positioning of the latter above the liquid solution, and the temperature of 1,000°C is maintained for a period of less than 1 hour before proceeding with the cooling mentioned in step 5).

15. The method according to claim 14, **characterized in that** the cooling of step 5) is carried out at a rate of less than 50°C.h⁻¹.

16. The method according to any of claims 1 to 13, **characterized in that** the cooling of step 4) is a heat treatment including an alternation of cooling steps and of temperature raising steps wherein the amplitude of each temperature raising step is less than the amplitude of the cooling step which precedes it.

17. The method according to claim 16, **characterized in that** the cooling of step 4) is carried out according to the following heat treatment:
i) cooling of the liquid solution from temperature T_{MP1} down to 1,150°C at a rate of 1°C.h⁻¹,
ii) raising the temperature from 1,150°C to 1,180°C at a rate of 120°C.h⁻¹,
iii) cooling from 1,180°C to 1,100°C at a rate of 0.7°C.h⁻¹,
iv) raising the temperature from 1,100°C to 1,150°C at a rate of 120°C.h⁻¹,
v) cooling from 1,150°C to 1,000°C (TCₒᵥₑᵣ) at a rate of 0.5°C.h⁻¹.

18. The method according to claim 16 or 17, **characterized in that** the cooling of step 5) is carried out at a rate of 50°C.h⁻¹.
